# EUROPEAN PATENT APPLICATION

(11) **EP 4 811 988 A1**
(43) Date of publication of application: **23.09.2026**
(21) Application number: 25878524.5
(22) Date of filing: 08.01.2025
(51) Int. Cl.: H10K 59/50, H10K 59/12

(54) **DISPLAY PANEL AND DISPLAY APPARATUS**

(30) Priority: 16.10.2024 CN 202411448983
(71) Applicant: Wuhan Tianma Microelectronics Co., Ltd., Wuhan, Hubei 430205 (CN)
(72) Inventor: MA, Hongshuai, Wuhan, Hubei 430205 (CN); JIN, Chunming, Wuhan, Hubei 430205 (CN)
(74) Representative: Lorenz & Kollegen
(86) International application number: PCT/CN2025/071154
(87) International publication number: WO 2026/081371

(57) **Abstract**

Provided are a display panel and a display device, which relate to the field of display technologies and for improving the large-viewing-angle anti-peeping effect of the display panel. The display panel includes a substrate, a light-emitting element located on a side of the substrate, a first light-adjusting interface protruding toward a direction away from the substrate and is misaligned with the light-emitting element in a direction perpendicular to a plane of the substrate, and a second light-adjusting interface recessed towards the substrate and misaligned with the light-emitting element in the direction perpendicular to the plane of the substrate. The first light-adjusting interface and the second light-adjusting interface are misaligned with each other in the direction perpendicular to the plane of the substrate.

## Description

### CROSS-REFERENCE TO RELATED APPLICATION

The present application claims priority to Chinese Patent Application No. 202411448983.5, entitled "Display Panel and Display Device", filed on October 16, 2024, the entire contents of which are incorporated herein by reference.

### TECHNICAL FIELD

The present disclosure relates to the field of display technologies, and in particular, to a display panel and a display device.

### BACKGROUND

With continuous development of display technologies, consumers have an increasing requirement for display screens. At present, various types of displays, including liquid crystal display screens and organic light-emitting display screens, have emerged one after another and achieved rapid development. On this basis, display technologies such as 3D display, touch display technology, curved display, ultra-high-resolution display, and anti-peeping display are constantly emerging.

At present, the improvement of anti-peeping performance of active light-emitting display screens including organic light-emitting diodes (OLED) has attracted great attention from researchers.

### SUMMARY

In view of this, the present disclosure provides a display panel and a display device, aiming to improve the anti-peeping effect of the display panel.

In an aspect, an embodiment of the present disclosure provides a display panel. The display panel includes a substrate; a light-emitting element located on a side of the substrate; a first light-adjusting interface protruding towards a direction away from the substrate and misaligned with the light-emitting element in a direction perpendicular to a plane of the substrate; and a second light-adjusting interface recessed towards the substrate and misaligned with the light-emitting element in the direction perpendicular to the plane of the substrate. The first light-adjusting interface and the second light-adjusting interface are misaligned with each other in the direction perpendicular to the plane of the substrate.

Optionally, at least part of the first light-adjusting interface is located at a light-exiting side of the light-emitting element; or, the second light-adjusting interface is located between two adjacent first light-adjusting interfaces in a direction parallel to the plane of the substrate.

Optionally, the display panel further comprises: a pixel definition layer, wherein the pixel definition layer comprises a first opening, the light-emitting element comprises a light-emitting layer, and at least part of the light-emitting layer is located in the first opening; and a protrusion portion protruding from a surface of the pixel definition layer towards a direction away from the substrate, wherein the protrusion portion comprises a first surface away from the substrate, wherein the first light-adjusting interface comprises the first surface.

Optionally, the pixel definition layer further comprises a second opening; and at least part of the second light-adjusting interface comprises a side wall of the second opening; the protrusion portion comprises a first bottom surface close to the substrate; and the second opening comprises a first top surface away from the substrate, the first bottom surface and the first top surface are located on a same horizontal plane that is parallel to the plane of the substrate.

Optionally, the display panel further comprises a support portion protruding from a surface of the pixel definition layer towards a direction away from the substrate; wherein the support portion comprises a second surface away from the substrate; and in the direction perpendicular to the plane of the substrate, a distance between the first surface and the light-emitting element is h1, and a distance between the second surface and the light-emitting element is h2, where 0<h1<h2≤3µm.

Optionally, the first surface intersects with the surface of the pixel definition layer at a first intersection line, and an included angle between a tangent line of the first surface at the first intersection line and the plane of the substrate is θ1, the second surface intersects the surface of the pixel definition layer at a second intersection line, and an included angle between a tangent line of the second surface at the second intersection line and the plane of the substrate is θ2, where 45°≤θ1≤θ2≤90°.

Optionally, in a direction parallel to the plane of the substrate, a distance between the protrusion portion and a light-emitting element closest to the protrusion portion is L1, and a distance between the support portion and a light-emitting element closest to the support portion is L2, where L1≤L2.

Optionally, the display panel further comprises a first film layer covering the protrusion portion, wherein a refractive index of the first film layer is smaller than a refractive index of the protrusion portion.

Optionally, the light-emitting element comprises a first electrode, a light-emitting layer, a common layer and a second electrode stacked in the direction perpendicular to the plane of the substrate, and the first film layer comprises the common layer.

Optionally, the display panel further comprises a pixel definition layer, wherein the pixel definition layer comprises a first opening and a second opening, the light-emitting element comprises a light-emitting layer, and at least part of the light-emitting layer is located in the first opening; and a side wall of the second opening comprises at least part of the second light-adjusting interface.

Optionally, the display panel further comprises a planarization layer located at a side of the pixel definition layer close to the substrate, wherein the planarization layer comprises a third opening, the third opening at least partially overlaps with the second opening in the direction perpendicular to the plane of the substrate, and at least part of the second light-adjusting interface comprises a side wall of the third opening.

Optionally, the display panel further comprises a second film layer at least partially located in the second opening and the third opening, wherein a refractive index of the second film layer is greater than a refractive index of the pixel definition layer, and the refractive index of the second film layer is greater than a refractive index of the planarization layer; and the light-emitting element comprises a first electrode, a light-emitting layer, a common layer and a second electrode stacked in the direction perpendicular to the plane of the substrate; and the second film layer comprises the common layer, and the common layer comprises at least one of a hole injection layer or a hole transport layer.

Optionally, the display panel comprises more than one first light-adjusting interface and second light-adjusting interface disposed corresponding to one of the light-emitting elements; the light-emitting elements comprise a first color light-emitting element and a second color light-emitting element, and a light-emitting efficiency of the first color light-emitting element is smaller than a light-emitting efficiency of the second color light-emitting element; the first light-adjusting interface comprises a first sub-light-adjusting interface disposed corresponding to the first color light-emitting element and a second sub-light-adjusting interface disposed corresponding to the second color light-emitting element; the second light-adjusting interface comprises a third sub-light-adjusting interface disposed corresponding to the first color light-emitting element and a fourth sub-light-adjusting interface disposed corresponding to the second color light-emitting element; and a number of the first sub-light-adjusting interfaces is greater than a number of the second sub-light-adjusting interfaces; and/or a number of the third sub-light-adjusting interfaces is greater than a number of the fourth sub-light-adjusting interfaces.

Optionally, the display panel further comprises light-emitting element groups arranged in an array in a first direction and a second direction, wherein the first direction intersects with the second direction; one light-emitting element group of the light-emitting element groups comprises light-emitting elements, and the light-emitting elements comprise a first color light-emitting element, a second color light-emitting element, and a third color light-emitting element; a length of the first color light-emitting element in the second direction is greater than a length of the second color light-emitting element in the second direction, and the length of the first color light-emitting element in the second direction is greater than a length of the third color light-emitting element in the second direction; and in one light-emitting element group of the light-emitting element groups, the first color light-emitting element and the second color light-emitting element are arranged in the first direction, the first color light-emitting element and the third color light-emitting element are arranged in the first direction, and the second color light-emitting element and the third color light-emitting element are arranged in the second direction.

Optionally, the first light-adjusting interface comprises at least a fifth light-adjusting sub-interface, and an orthographic projection of the fifth light-adjusting sub-interface onto the plane of the substrate is located between the third color light-emitting element of one light-emitting element group of the light-emitting element groups and the second color light-emitting element of another one light-emitting element group of the light-emitting element groups; and the second light-adjusting interface comprises at least a sixth light-adjusting sub-interface, and an orthographic projection of the second light-adjusting sub-interface onto a plane of the substrate is located between the third color light-emitting element of one light-emitting element group of the light-emitting element groups and the second color light-emitting element of another one light-emitting element group of the light-emitting element groups; or, the first light-adjusting interface further comprises a seventh light-adjusting sub-interface, and an orthographic projection of the seventh light-adjusting sub-interface onto the plane of the substrate is located between the first color light-emitting element and the second color light-emitting element; and/or, an orthographic projection of the seventh light-adjusting sub-interface onto the plane of the substrate is located between the first color light-emitting element and the third color light-emitting element; and the second light-adjusting interface further comprises an eighth sub-light-adjusting interface, and an orthographic projection of the eighth sub-light-adjusting interface onto the plane of the substrate is located between the first color light-emitting element and the second color light-emitting element; and/or an orthographic projection of the eighth sub-light-adjusting interface onto the plane of the substrate is located between the first color light-emitting element and the third color light-emitting element; or, the first color light-emitting element comprises a first sub-light-emitting element and a second sub-light-emitting element arranged in the second direction, and a third sub-light-emitting element and a fourth sub-light-emitting element arranged in the second direction; and a distance between the first sub-light-emitting element and the second sub-light-emitting element in the second direction is equal to a distance between the third sub-light-emitting element and the fourth sub-light-emitting element in the second direction.

Optionally, the display panel further comprises a support portion protruding from a surface of the pixel definition layer towards a direction away from the substrate, wherein an orthographic projection of the support portion onto the plane of the substrate is located between two adjacent first color light-emitting elements arranged in the second direction.

Optionally, the display panel comprises a light-adjusting assembly, the light-adjusting assembly comprises the first light-adjusting interface and the second light-adjusting interface, and the light-adjusting assembly and the support portion are arranged in the first direction; or the first color light-emitting element comprises a first sub-light-emitting element and a second sub-light-emitting element arranged in the second direction, and a third sub-light-emitting element and a fourth sub-light-emitting element arranged in the second direction; a distance d1 between the first sub-light-emitting element and the second sub-light-emitting element in the second direction is smaller than a distance d2 between the third sub-light-emitting element and the fourth sub-light-emitting element in the second direction; and at least two of the support portion, the first light-adjusting interface and the second light-adjusting interface are provided between the third sub-light-emitting element and the fourth sub-light-emitting element.

Optionally, the display panel comprises a light-adjusting assembly, and the light-adjusting assembly comprises the first light-adjusting interface and the second light-adjusting interface; and the light-adjusting assembly comprises a first light-adjusting assembly at least partially surrounding the first color light-emitting element, a second light-adjusting assembly at least partially surrounding the second color light-emitting element, and a third light-adjusting assembly at least partially surrounding the third color light-emitting element.

Optionally, the display panel further comprises at least one of a first connection assembly, a second connection assembly, a third connection assembly or a fourth connection assembly, wherein the first connection assembly connects the first light-adjusting assembly and the second light-adjusting assembly that are adjacent in the first direction, the second connection assembly connects the second light-adjusting assembly and the third light-adjusting assembly that are adjacent in the second direction, the third connection assembly connects the third light-adjusting assembly and the first light-adjusting assembly that are adjacent in the first direction, and the fourth connection assembly connects two first light-adjusting assemblies that are adjacent to each other in the second direction.

In another aspect, an embodiment of the present disclosure provides a display device including the display panel described above.

According to the display panel and the display device provided by the embodiments of the present disclosure, the first light-adjusting interface and the second light-adjusting interface are arranged in the display panel, and the first light-adjusting interface protrudes towards a direction away from the substrate, and the second light-adjusting interface is recessed towards the substrate, so that a propagation direction of the large-angle light emitted by the light-emitting element can be adjusted by using the first light-adjusting interface and the second light-adjusting interface. The adjusted light can be emitted from the display panel at a small angle, thereby preventing the light of the light-emitting element from exiting from the display panel at a relatively large angle, preventing a user located at a large viewing-angle from seeing or viewing a display image clearly, and thus achieving the large-viewing-angle anti-peeping effect. Moreover, based on this arrangement, the first light-adjusting interface and the second light-adjusting interface may also be configured to adjust the original large-angle light into small-angle light to exit from the display panel, thereby improving the light-emitting utilization efficiency of the light-emitting element, increasing the brightness of the display panel at the front viewing-angle, and reducing the power consumption of the display panel while ensuring the display brightness of the display panel at the front viewing-angle.

When the display panel is applied to a vehicle-mounted display screen, the first light-adjusting interface and the second light-adjusting interface can narrow the large-angle light emitted by the vehicle-mounted display screen, such as light directed towards the windshield. For example, the light can be adjusted to be parallel light, which alleviates the problem of windshield reflection and achieves anti-peeping.

### BRIEF DESCRIPTION OF DRAWINGS

In order to better illustrate the technical solutions in embodiments of the present disclosure, the drawings, which are intended to be used in the description of embodiments, are briefly described as below. It will be apparent that other drawings described below are merely some embodiments of the present disclosure, and other drawings may be obtained by those skilled in the art according to these drawings without paying any creative efforts.
FIG. 1 is a schematic diagram of a display panel according to an embodiment of the present disclosure;
FIG. 2 is a schematic cross-sectional view of FIG. 1 along line AA';
FIG. 3 is a schematic cross-sectional view of FIG. 1 along line BB';
FIG. 4 is another schematic cross-sectional view of FIG. 1 along line AA';
FIG. 5 is another schematic cross-sectional view of FIG. 1 along line AA';
FIG. 6 is another schematic cross-sectional view of FIG. 1 along line AA';
FIG. 7 is another schematic cross-sectional view of FIG. 1 along line AA';
FIG. 8 is a schematic top view of a display panel according to an embodiment of the present disclosure;
FIG. 9 is a schematic top view of another display panel according to an embodiment of the present disclosure;
FIG. 10 is a schematic top view of another display panel according to an embodiment of the present disclosure;
FIG. 11 is a schematic top view of another display panel according to an embodiment of the present disclosure;
FIG. 12 is a schematic top view of another display panel according to an embodiment of the present disclosure; and
FIG. 13 is a schematic diagram of a display device according to an embodiment of the present disclosure.

### DESCRIPTION OF EMBODIMENTS

In order to better understand the technical solutions of the present disclosure, embodiments of the present disclosure are described in detail below in conjunction with the drawings.

It is to be clear that the described embodiments are only some rather than all of the embodiments of the present disclosure. All other embodiments obtained by those skilled in the art without creative efforts according to embodiments of the present disclosure shall fall within the protection scope of the present disclosure.

Terms used in the embodiments of the present disclosure are merely for the purpose of describing specific embodiments, but not intended to limit the present disclosure. Terms "a/an", and "the/said" in a singular form in embodiments of the present disclosure and the attached claims are also intended to include plural forms thereof, unless explicitly noted otherwise in the context.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

At present, a flexible vehicle-mounted product is generally an anti-peeping film externally attached onto a module cover plate. A principle of the anti-peeping film is to reduce a distance between shutter blades of a louver according to a certain rule to form a layer of ultra-fine blades in the louver, so that light at the front viewing angle is only blocked by the narrowest area of the blades. In this way, human eyes have a highest transmittance and strongest visibility when viewing a screen. As the increase of the inclination angle, an area of light blocked by the blades increases, and the visible transmittance decreases accordingly, causing the screen to gradually darken. When the inclination angle is increased to a certain extent, the screen becomes completely dark, thereby making it impossible for human eyes to see any content, and thus achieving the purpose of protecting the privacy of the screen content. However, this method increases the cost and thickness of the display device, which is not conducive to thin and light displays.

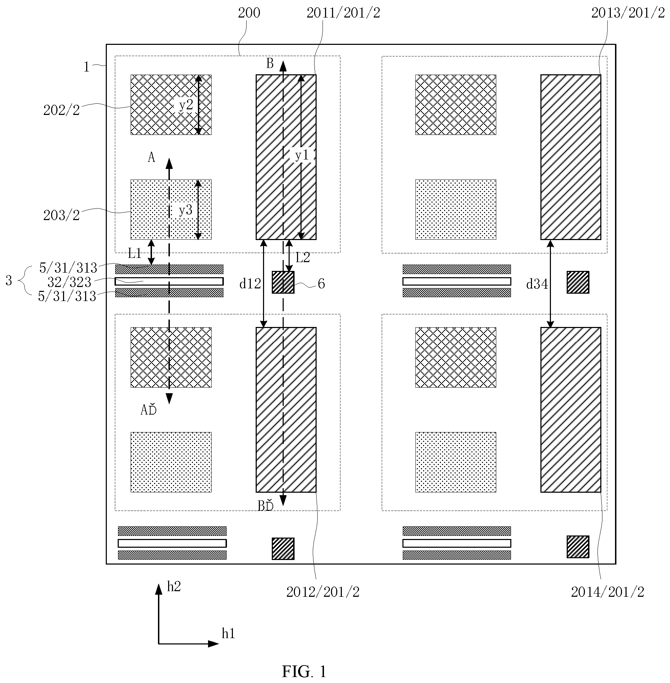

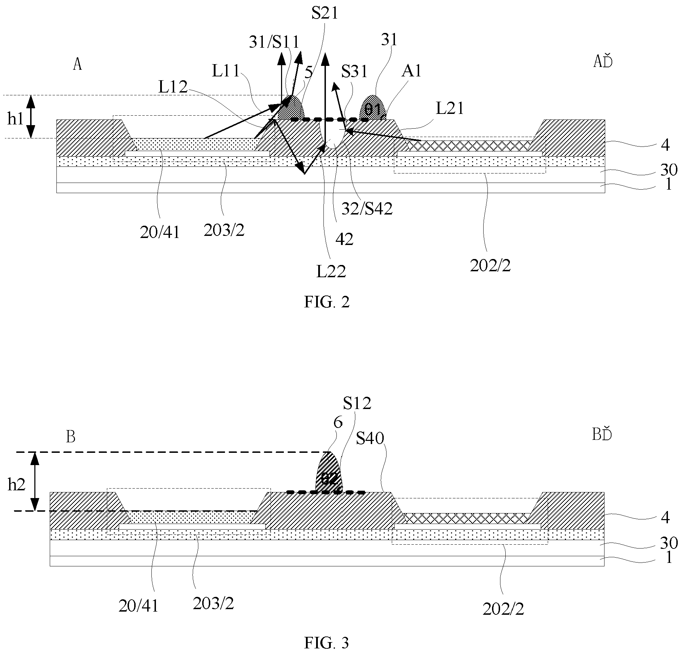

In view of this, an embodiment of the present disclosure provides a display panel, as shown in FIG. 1 and FIG. 2, FIG. 1 is a schematic diagram of a display panel according to an embodiment of the present disclosure, and FIG. 2 is a schematic cross-sectional view of FIG. 1 along line AA'. The display panel includes a substrate 1, a light-emitting element 2, a first light-adjusting interface 31 and a second light-adjusting interface 32.

As shown in FIG. 2, the light-emitting element 2 is located on a side of the substrate 1. The first light-adjusting interface 31 protrudes toward a direction away from the substrate 1, and is misaligned with the light-emitting element 2 in a direction perpendicular to a plane of the substrate 1. The second light-adjusting interface 32 is recessed towards the substrate 1 and misaligned with the light-emitting element 2 in the direction perpendicular to the plane of the substrate 1.

When the display panel operates, the light-emitting element 2 emits light with various exit angles. For the large-angle light emitted by the light-emitting element 2, the large-angle light refers to light with an included angle between a propagation direction of the light and a normal line of the substrate greater than a first preset angle, and this light may be adjusted by the first light-adjusting interface 31 and the second light-adjusting interface 32 to be a small-angle light emitted from the display panel. The small-angle light refers to light with an included angle between the propagation direction of the light and the normal line of the substrate smaller than the first preset angle. The first preset angle may be set according to the anti-peeping requirement of the viewing-angle of the display panel. For example, in an embodiment of the present disclosure, the first preset angle may be set to be 45° or 60°.

In an embodiment, as shown in FIG. 2, the light L11 is reflected after being emitted to the first light-adjusting interface 31, and the reflected light may be emitted from the display panel at a smaller exit angle than that of the light L11. The exit angle refers to an included angle between the propagation direction of the light and the normal line of the substrate 1. As shown in FIG. 2, the light L12 is refracted after being emitted to the first light-adjusting interface 31, and the refracted light may be emitted from the display panel at a smaller exit angle than that of the light L12.

As shown in FIG. 2, the light L21 represents the light emitted by the light-emitting element 2 and reflected by other film layers inside the display panel and emitted to the second light-adjusting interface 32, and the light may be emitted at a smaller exit angle after being refracted by the second light-adjusting interface 32. As shown in FIG. 2, the light L22 represents a large-angle light emitted by the light-emitting element 2 and directly emitted to the second light-adjusting interface 32, and after being refracted by the second light-adjusting interface 32, the light may be emitted at a smaller angle.

It can be seen that, based on the above arrangement provided by the embodiments of the present disclosure, the emitted light of the light-emitting element 2 can be prevented from emitting from the display panel at a relatively large exit angle, preventing a user located at a large viewing-angle from seeing or viewing a display image clearly, and thus achieving the large-viewing-angle anti-peeping effect. Moreover, based on this arrangement, the first light-adjusting interface 31 and the second light-adjusting interface 32 can be configured to adjust the original large-angle light into small-angle light to emit from the display panel, thereby improving the light-emitting utilization efficiency of the light-emitting element 2, increasing the brightness of the display panel at the front viewing-angle, and reducing the power consumption of the display panel while ensuring the display brightness of the display panel at the front viewing-angle.

When the display panel is applied to a vehicle-mounted display screen, the first light-adjusting interface 31 and the second light-adjusting interface 32 can narrow the large-angle light emitted by the vehicle-mounted display screen, such as light directed toward the windshield. For example, the light can be adjusted into parallel light, which alleviates the problem of windshield reflection and achieves anti-peeping.

Exemplarily, as shown in FIG. 1 and FIG. 2, in the direction perpendicular to the plane of the substrate 1, the first light-adjusting interface 31 and the second light-adjusting interface 32 are misaligned with the light-emitting element 2, and the first light-adjusting interface 31 and the second light-adjusting interface 32 are also misaligned with each other, so as to prevent the first light-adjusting interface 31 and the second light-adjusting interface 32 from adjusting the small-angle light emitted by the light-emitting element 2, which can ensure the display effect of the display panel at the front viewing-angle. In addition, in this embodiment of the present disclosure, the first light-adjusting interface 31 and the second light-adjusting interface 32 are misaligned with each other in the direction perpendicular to the plane of the substrate 1, thereby adjusting various large-angle light emitted by the light-emitting element 2.

In addition, as shown in FIG. 2, the display panel further includes an array layer 30. The array layer 30 includes a metal trace (not shown in FIG. 2) and a pixel driving circuit (not shown in FIG. 2) electrically connected to the light-emitting element 2. The pixel driving circuit includes a thin film transistor. Exemplarily, for the light emitted by the light-emitting element 2 and propagating towards the substrate 1, the metal trace may reflect this part of light, and the reflected light may be emitted to the second light-adjusting interface 32 and be adjusted by the second light-adjusting interface 32 and then emitted from the display panel at a relatively small exit angle, thereby further improving the anti-peeping effect at a large-viewing-angle and increasing the brightness of the display panel at the front viewing-angle. Moreover, based on this arrangement, the light can be prevented from being emitted to the thin film transistor, thereby preventing the characteristics of the thin film transistor from changing due to the illumination, and thus ensuring that the thin film transistor has reliable electrical performance.

Exemplarily, as shown in FIG. 2, at least part of the first light-adjusting interface 31 is located on the light-exiting side of the light-emitting element 2. That is, in the direction perpendicular to the plane of the substrate 1, at least part of the first light-adjusting interface 31 is located on a side of the light-emitting element 2 away from the substrate 1. Based on this arrangement, at least part of the large-angle light emitted by the light-emitting element 2 and propagated towards a direction away from the substrate 1 may be emitted to the first light-adjusting interface 31, and the first light-adjusting interface 31 may adjust the propagation direction of this part of the large-angle light, so that this part of the large-angle light is emitted from the first light-adjusting interface 31 at a relatively small exit angle.

Exemplarily, as shown in FIG. 1, in an embodiment of the present disclosure, the first light-adjusting interface 31 and the second light-adjusting interface 32 may be located between two adjacent light-emitting elements 2. Based on this arrangement, a distance between the first light-adjusting interface 31 and the second light-adjusting interface 32 can be reduced, so that at least part of the large-angle light emitted by a same light-emitting element 2 can be sequentially adjusted by the first light-adjusting interface 31 and the second light-adjusting interface 32, thereby further reducing the exit angle of the emitted light.

Exemplarily, as shown in FIG. 1 and FIG. 2, in an embodiment of the present disclosure, the second light-adjusting interface 32 may be located on a side of the first light-adjusting interface 31 away from the light-emitting element 2. At least two first light-adjusting interfaces 31 and at least one second light-adjusting interface 32 are provided between two adjacent light-emitting elements 2. The second light-adjusting interface 32 is located between two adjacent first light-adjusting interfaces 31 in a direction parallel to the plane of the substrate 1. Based on this arrangement, at least part of the light that may be emitted through the second light-adjusting interface 32 may continue to be emitted to the first light-adjusting interface 31 located on both sides of the second light-adjusting interface 32, so that this part of light may continue to have a reduced exit angle by means of an effect of the first light-adjusting interface 31.

Exemplarily, as shown in FIG. 2, at least part of the second light-adjusting interface 32 is located on a side of the light-emitting element 2 close to the substrate 1. Based on this arrangement, at least part of the large-angle light emitted by the light-emitting element 2 and propagated towards the substrate 1 may be emitted to the second light-adjusting interface 32, and the second light-adjusting interface 32 may adjust the propagation direction of this part of the large-angle light, so that this part of the large-angle light is emitted from the second light-adjusting interface 32 at a relatively small exit angle.

Exemplarily, as shown in FIG. 2, the display panel further includes a pixel definition layer 4 and a protrusion portion 5. The pixel definition layer 4 includes a first opening 41. The light-emitting element 2 includes a light-emitting layer 20. At least part of the light-emitting layer 20 is located in the first opening 41. The protrusion portion 5 protrudes from a surface of the pixel definition layer 4 towards a direction away from the substrate 1. The protrusion portion 5 includes a first surface S11 away from the substrate 1. The first light-adjusting interface 31 includes the first surface S11. That is, when the light emitted by the light-emitting element 2 is emitted to the first surface S11, the exit angle of the light emitted through the first surface S11 may be reduced, thereby reducing the brightness of the display panel at a large-viewing-angle and achieving the large-viewing-angle anti-peeping effect.

In an embodiment, as shown in FIG. 2, the pixel definition layer 4 further includes a second opening 42. At least part of the second light-adjusting interface 32 includes a side wall S42 of the second opening 42. That is, after the light emitted by the light-emitting element 2 is emitted to the side wall S42, the exit angle of the light emitted through the side wall S42 may be reduced, thereby reducing the brightness of the display panel at a large-viewing angle and achieving the large-viewing-angle anti-peeping effect.

Exemplarily, the second opening 42 and the third opening 43 may be formed in a same patterning process. The protrusion portion 5 may be formed either before or after the formation of the second opening 42.

Exemplarily, the material of the protrusion 5 may be different from that of the pixel definition layer 4, or may be the same as that of the pixel definition layer 4, which is not limited in the embodiments of the present disclosure.

Exemplarily, as shown in FIG. 2, the protrusion portion 5 includes a first bottom surface S21 close to the substrate 1. The second opening 42 includes a first top surface S31 away from the substrate 1. The first top surface S31 may be understood as a portion of the side wall S42 that forms the second opening 42, which has a maximum distance from the substrate 1. As shown in FIG. 2, the first bottom surface S21 and the first top surface S31 are located on a same horizontal plane, which is parallel to the plane of the substrate 1. FIG. 2 illustrates the horizontal plane with a dashed line. The horizontal plane may serve as a boundary between the first light-adjusting interface 31 and the second light-adjusting interface 32, that is, the first light-adjusting interface 31 and the second light-adjusting interface 32 are respectively located on two sides of the horizontal plane in the direction perpendicular to the plane of the substrate 1.

Exemplarily, as shown in FIG. 2, the horizontal plane may be regarded as a surface S40 of the pixel definition layer 4.

Exemplarily, as shown in FIG. 1 and FIG. 3, FIG. 3 is a schematic cross-sectional view of FIG. 1 along line BB', the display panel further includes a support portion 6 protruding from the surface S40 of the pixel definition layer 4 towards a direction away from the substrate 1. The support portion 6 is configured to support a mask during the evaporation process, so as to ensure evaporation uniformity and improve the evaporation yield.

As shown in FIG. 3, the support portion 6 includes a second surface S12 away from the substrate 1. A distance between the second surface S12 and the light-emitting element 2 is h2 in the direction perpendicular to the plane of the substrate 1. As shown in FIG. 2, a distance between the first surface S11 and the light-emitting element 2 is h1 in the direction perpendicular to the plane of the substrate 1, where 0<h1<h2≤3µm. Based on this arrangement, when the support portion 6 is configured to support the mask, contact between the mask and the protrusion 5 can be avoided, thereby avoiding the occurrence of abnormalities such as scratches on the protrusion 5, improving the structural reliability of the protrusion portion 5, and thus enabling the protrusion portion 5 to be configured to adjust the large-angle light emitted by the light-emitting element 2.

Exemplarily, in an embodiment of the present disclosure, a bottom surface of the support portion 6 close to the substrate 1 and a bottom surface of the protrusion portion 5 close to the substrate 1 may be located on a same horizontal plane. A height of the protrusion portion 5 may be smaller than a height of the support portion 6, so as to prevent the mask from contacting the protrusion portion 5 when the support portion 6 is configured to support the mask.

Exemplarily, as shown in FIG. 2, the first surface S11 intersects with the surface S40 of the pixel definition layer 4 at a first intersection line A1, and an included angle between a tangent line of the first surface S11 at the first intersection line A1 and the plane of the substrate 1 is θ1. As shown in FIG. 3, the second surface S12 intersects with the surface of the pixel definition layer 4 at a second intersection line A2, and an included angle between a tangent line of the second surface S12 at the second intersection line A2 and the plane of the substrate 1 is θ2, where 45°≤θ1≤θ2≤90°.

Based on this arrangement, on the one hand, the included angle between the tangent line of the first surface S11 at the first intersection line A1 and the plane of the substrate 1 may be relatively small, that is, the inclination degree of the first surface S11 relative to the plane of the substrate 1 is relatively slight, so that the first surface S11 can receive more large-angle light emitted by the light-emitting element 2, and adjust more large-angle light to be emitted at a small angle, thereby further improving the large-viewing-angle anti-peeping effect of the display panel. On the other hand, in this embodiment of the present disclosure, by making the included angle between the tangent line of the second surface S12 at the second intersection line A2 and the plane of the substrate 1 relatively large, the second surface S12 may be inclined to a greater degree relative to the plane of the substrate 1, so that the height of the support portion 6 reaches the height required for supporting the mask, and meanwhile, the area of the support portion 6 may be prevented from being relatively large, which is beneficial to using more space in the display panel for arranging the light-emitting element 2, that is, increasing the area of the light-emitting element 2 and improving the aperture ratio.

In an embodiment, as shown in FIG. 1, in the direction parallel to the plane of the substrate 1, a distance between the protrusion portion 5 and a light-emitting element 2 closest thereto is L1, and a distance between the support portion 6 and a light-emitting element 2 closest thereto is L2, where L1≤L2. Based on this arrangement, the distance between the protrusion portion 5 and the light-emitting element 2 can be smaller, so that the first surface S11 of the protrusion portion 5 can receive more large-angle light emitted by the light-emitting element 2, and convert more large-angle light into small-angle light for emission, which is beneficial to reducing the intensity of the large-angle light and improving the anti-peeping effect.

Exemplarily, as shown in FIG. 2, a width of the protrusion portion 5 gradually decreases in the direction away from the substrate 1. The light emitted by the light-emitting element 2 can be reflected when being emitted to the first surface S11. In this embodiment of the present disclosure, the width of the protrusion portion 5 gradually decreases in the direction away from the substrate 1, so that the light reflected by the first surface S11 can be emitted towards the light-exiting side of the display panel, which is beneficial to improving the brightness of the display panel. Moreover, based on this arrangement, when other film layers are continuously formed above the protrusion portion 5 subsequently, the film layer disposed above the protrusion portion 5 can be prevented from being disconnected at the position of the protrusion portion 5. For example, when a cathode of the light-emitting element 2 is disposed above the protrusion portion 5, based on this arrangement, the cathode can be prevented from being disconnected at the protrusion portion 5, which is beneficial to improving the connection reliability of the cathode.

Exemplarily, as shown in FIG. 2, the width of the second opening 42 gradually decreases in the direction close to the substrate 1. Based on this arrangement, when other film layers are continuously formed above the second opening 42, the film layer disposed above the second opening 42 may be prevented from being disconnected at the position of the second opening 42. For example, when a cathode of the light-emitting element 2 is disposed above the second opening 42, based on this arrangement, the cathode can be prevented from being disconnected at the second opening 42, which is beneficial to improving the connection reliability of the cathode.

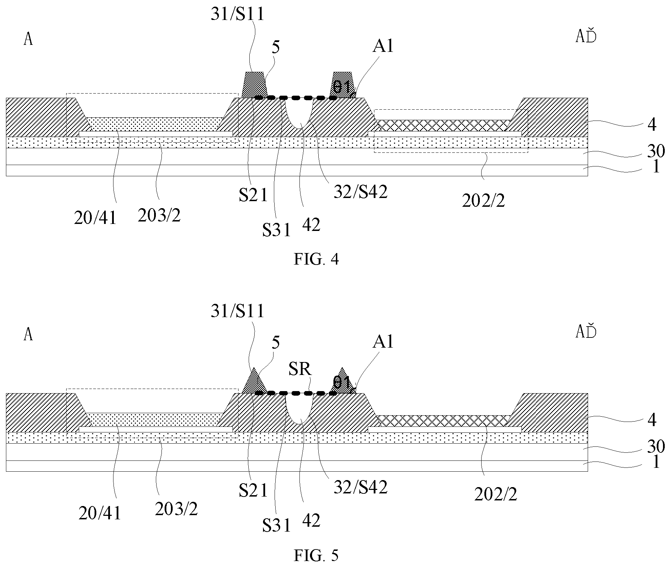

Exemplarily, as shown in FIG. 2, a side of the first light-adjusting interface 31 away from the substrate 1 may include a curved surface. FIG. 2 illustrates that a cross-sectional shape of the first light-adjusting interface 31 is an arc. Alternatively, in an embodiment of the present disclosure, a side of the first light-adjusting interface 31 away from the substrate 1 may include a planar surface. As shown in FIG. 4 and FIG. 5, FIG. 4 and FIG. 5 are another two schematic cross-sectional diagrams of FIG. 1 along line AA'. In FIG. 4, a cross-sectional shape of the first light-adjusting interface 31 is a trapezoid. In FIG. 5, a cross-sectional shape of the first light-adjusting interface 31 is a triangle.

In an embodiment of the present disclosure, a side of the second light-adjusting interface 32 close to the substrate 1 may include a planar surface or a curved surface.

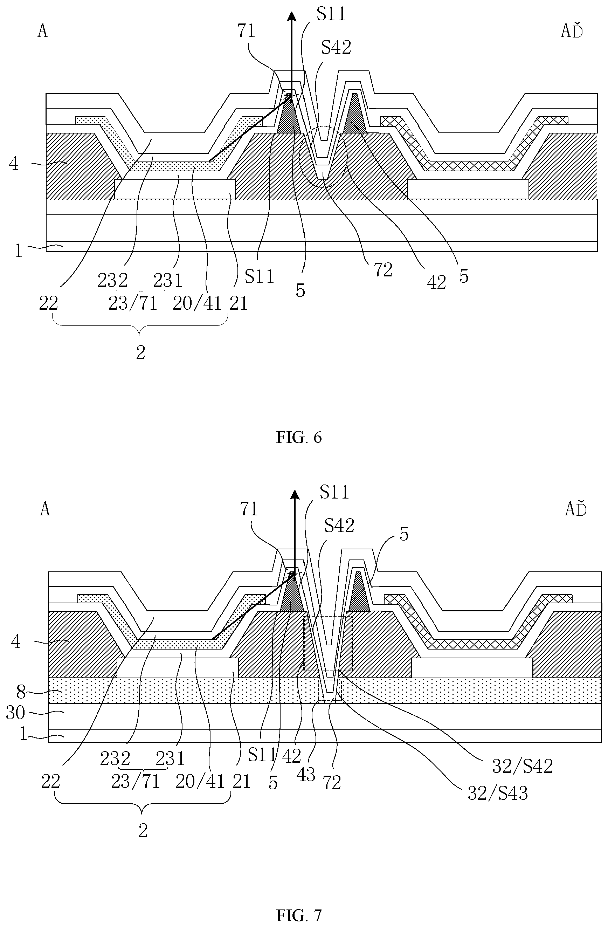

Exemplarily, as shown in FIG. 6, which is still another schematic cross-sectional view of FIG. 1 along line AA', the display panel further includes a first film layer 71 covering the protrusion portion 5. The first film layer 71 is in contact with the protrusion portion 5, and the first surface S11 is a contact surface therebetween. In an embodiment of the present disclosure, a refractive index of the first film layer 71 is smaller than a refractive index of the protrusion portion 5.

When the light-emitting element 2 is turned on, as shown in FIG. 6, the large-angle light emitted by the light-emitting element 2 may irradiate the interface between the protrusion portion 5 and the first film layer 71, that is, the first surface S11. In this embodiment of the present disclosure, by making the refractive index of the first film layer 71 smaller than the refractive index of the protrusion portion 5, when the light passes through the first surface S11 from the inside of the protrusion portion 5 to the first film layer 71, according to the Snell's Law, the propagation direction of the light passing through the first surface S11 may be deflected towards the normal direction of the substrate 1, that is, the first surface S11 may adjust the large-angle light into small-angle light for emission, which thus can increase the brightness at the front viewing-angle, reduce the intensity of large-angle light, and achieve the large-viewing-angle anti-peeping effect.

Exemplarily, as shown in FIG. 6, the light-emitting element 2 includes a first electrode 21, a light-emitting layer 20, a common layer 23 and a second electrode 22 stacked in the direction perpendicular to the plane of the substrate 1, and in this embodiment of the present disclosure, the first film layer 71 includes the common layer 23. In an embodiment, the common layer 23 includes a first sub-common layer 231 and/or a second sub-common layer 232. At least part of the first sub-common layer 231 is located between the first electrode 21 and the light-emitting layer 20, and at least part of the second sub-common layer 232 is located between the second electrode 22 and the light-emitting layer 20. In an embodiment, the first electrode 21 includes an anode, while the second electrode 22 includes a cathode. The first sub-common layer 231 includes a hole injection layer and/or a hole transport layer. At least part of the second sub-common layer 232 includes an electron injection layer and/or an electron transport layer.

In an embodiment, as shown in FIG. 6, the display panel further includes a second film layer 72 at least partially located in the second opening 42. The second film layer 72 is in contact with a side wall S42 of the second opening 42. A portion of the second light-adjusting interface 32 is a contact surface between the second film layer 72 and the side wall S42 of the second opening 42. In this embodiment of the present disclosure, a refractive index of the second film layer 72 is greater than a refractive index of the pixel definition layer 4. Based on this arrangement, the large-angle light emitted from the pixel definition layer 4 to the second film layer 72 through the second light-adjusting interface 32 can be adjusted to the small-angle light according to the Snell's Law.

Exemplarily, as shown in FIG. 7, which is still another schematic cross-sectional view of FIG. 1 along line AA', the display panel further includes a planarization layer 8, which is located on a side of the pixel definition layer 4 close to the substrate 1. The planarization layer 8 includes a third opening 43. The third opening 43 at least partially overlaps with the second opening 42 in the direction perpendicular to the plane of the substrate 1. At least part of the second light-adjusting interface 32 includes a side wall S43 of the third opening 43. The arrangement of the third opening 43 may increase the area of the second light-adjusting interface 32 based on the second opening 42, so that the second light-adjusting interface 32 receives more large-angle light emitted by the light-emitting element 2, and adjust more large-angle light emitted by the light-emitting element 2, thereby avoiding more large-angle light from being emitted from the display panel, and further improving the large-view anti-peeping effect of the display panel.

Exemplarily, as shown in FIG. 7, at least part of the second film layer 72 is further located in the third opening 43. The second film layer 72 is respectively in contact with the side wall S42 of the second opening 42 and the side wall S43 of the third opening 43. A portion of the second light-adjusting interface 32 is a contact surface between the second film layer 72 and the side wall S42 of the second opening 42, and another portion of the second light-adjusting interface 32 is a contact surface between the second film layer 72 and the side wall S43 of the third opening 43. In this embodiment of the present disclosure, a refractive index of the second film layer 72 is greater than a refractive index of the planarization layer 8. Based on this arrangement, the large-angle light emitted from the planarization layer 8 to the second film layer 72 through the second light-adjusting interface 32 can be adjusted to the small-angle light according to the Snell's Law.

It should be noted that the arrangement of the third opening 43 penetrating through the planarization layer 8 shown in FIG. 7 is merely illustrative, and the depth of the third opening 43 may be smaller than the thickness of the planarization layer 8, that is, the third opening 43 does not pass through the planarization layer 8.

Exemplarily, as shown in FIG. 7, the light-emitting element 2 includes a first electrode 21, a light-emitting layer 20, a common layer 23 and a second electrode 22 stacked in the direction perpendicular to the plane of the substrate 1, and the second film layer 72 includes the common layer 23. In an embodiment, the common layer 23 includes a first sub-common layer 231 and/or a second sub-common layer 232. At least part of the first sub-common layer 231 is located between the first electrode 21 and the light-emitting layer 20, and at least part of the second sub-common layer 232 is located between the second electrode 22 and the light-emitting layer 20. In an embodiment, the first electrode 21 includes an anode, while the second electrode 22 includes a cathode. The first sub-common layer 231 includes a hole injection layer and/or a hole transport layer. At least part of the second sub-common layer 232 includes an electron injection layer and/or an electron transport layer.

Exemplarily, the second film layer 72 and the first film layer 71 may be formed by a same material in a same process, and may be two parts of a same film layer in different regions. That is, there may be no boundary therebetween.

In this case, the refractive index of the protrusion portion 5 is different from the refractive index of the pixel definition layer 4. The protrusion portion 5 and the pixel definition layer 4 may be respectively formed by different materials.

As shown in FIG. 6 and FIG. 7, based on the morphological characteristics of the protrusion portion 5, a transmission path of the lateral leakage current between two adjacent light-emitting elements 2 through the common layer 23 can be prolonged, thereby suppressing the transmission of the lateral leakage current, preventing the false lighting of light-emitting element 2 that should not be turned on, and thus improving the display effect.

In addition, the common layer 23 formed after the second opening 42 is formed on the side wall S42 of the second opening 42. Based on the morphological characteristics of the second opening 42, the transmission path of the lateral leakage current between two adjacent light-emitting elements 2 through the common layer 23 can be prolonged, thereby suppressing the transmission of the lateral leakage current, and thus improving the display effect.

Exemplarily, as shown in FIG. 1, orthographic projections of the first light-adjusting interface 31 and the second light-adjusting interface 32 onto the plane of the substrate 1 may be strip-shaped structures. As shown in FIG. 1, lengths of the first light-adjusting interface 31 and the second light-adjusting interface 32 in the first direction h1 are respectively greater than their respective lengths in the second direction h2.

Alternatively, in this embodiment of the present disclosure, the orthographic projection of at least one of the first light-adjusting interface 31 and the second light-adjusting interface 32 onto the plane of the substrate 1 may be configured as a block-shaped structure.

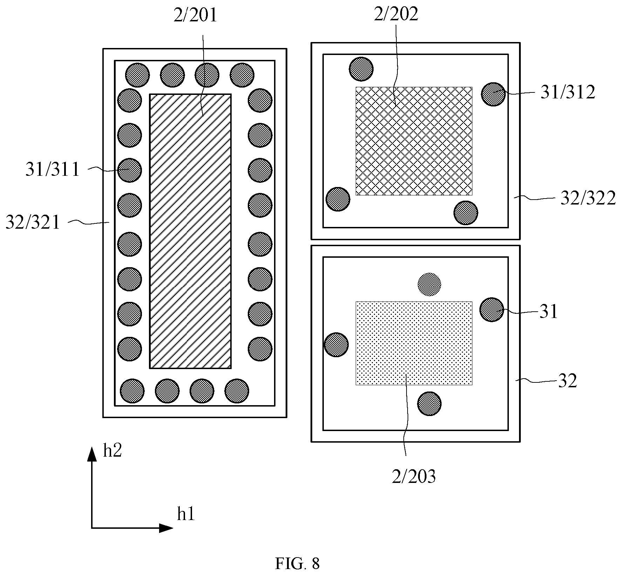

Exemplarily, as shown in FIG. 8, which is a schematic top view of a display panel according to an embodiment of the present disclosure, the display panel includes first light-adjusting interfaces 31 and second light-adjusting interfaces 32 corresponding to the light-emitting element 2. An orthographic projection of the first light-adjusting interface 31 onto the plane of the substrate 1 is a block-shaped structure with approximately equal lengths in the first direction h1 and the second direction h2. FIG. 8 illustrates that the orthographic projection of the first light-adjusting interface 31 onto the plane of the substrate can be configured a circular shape. Of course, it can also be set as a polygonal shape, which is limited in the embodiments of the present disclosure.

As shown in FIG. 8, the light-emitting element 2 includes a first color light-emitting element 201 and a second color light-emitting element 202. The first light-adjusting interface 31 includes a first sub-light-adjusting interface 311 disposed corresponding to the first color light-emitting element 201 and a second sub-light-adjusting interface 312 disposed corresponding to the second color light-emitting element 202. The second light-adjusting interface 32 includes a third sub-light-adjusting interface 321 disposed corresponding to the first color light-emitting element 201 and a fourth sub-light-adjusting interface 322 disposed corresponding to the second color light-emitting element 202.

In this embodiment of the present disclosure, a light-emitting efficiency of the first color light-emitting element 201 is smaller than that of the second color light-emitting element 202. A number of the first sub-light-adjusting interfaces 311 is greater than that of the second sub-light-adjusting interfaces 312. And/or a number of the third sub-light-adjusting interfaces 321 is greater than that of the fourth sub-light-adjusting interfaces 322. Based on this arrangement, the number of the first sub-light-adjusting interfaces 311 and the second sub-light-adjusting interfaces 312 can be matched with the light-emitting efficiency of the first color light-emitting element 201 and the second color light-emitting element 202 respectively, so that a relatively large number of the first sub-light-adjusting interfaces 321 are arranged at the periphery of the first color light-emitting element 201 with a relatively small light-emitting efficiency, so that the relatively large number of the first sub-light-adjusting interfaces 311 can adjust the large-angle light emitted by the light-emitting element 2, and adjust more large-angle light to be small-angle light for emission, thereby increasing the intensity of the small-angle light emitted by the first color light-emitting element 201 to compensate for the deficiency of the light-emitting efficiency of the first color light-emitting element 201.

Exemplarily, the light-emitting element 2 includes an organic light-emitting diode (OLED), the first color may be blue, the second color may be one of green and red, and the third color may be another one of green and red.

Exemplarily, as shown in FIG. 8, the light-emitting element 2 further includes a third color light-emitting element 203. In this embodiment of the present disclosure, the light-emitting efficiency of the first color light-emitting element 201 is smaller than the light-emitting efficiency of the third color light-emitting element 203. The number of the first sub-light-adjusting interfaces 311 is greater than the number of the first light-adjusting interfaces 31 around the third color light-emitting element 203. And/or the number of the third sub-light-adjusting interfaces 321 is greater than the number of the second light-adjusting interfaces 32 around the third color light-emitting element 203.

Exemplarily, as shown in FIG. 8, the area of the first color light-emitting element 201 may be greater than the area of the second color light-emitting element 202, to compensate for the deficiency of the light-emitting efficiency of the first color light-emitting element 201.

Exemplarily, as shown in FIG. 1, the display panel includes light-emitting element groups 200 arranged in an array in the first direction h1 and the second direction h2. FIG. 1 illustrates 2×2 light-emitting element groups in the display panel. The first direction h1 intersects with the second direction h2. The light-emitting element group 200 includes a plurality of light-emitting elements 2 described above. The light-emitting elements 2 include a first color light-emitting element 201, a second color light-emitting element 202 and a third color light-emitting element 203. A length y1 of the first color light-emitting element 201 in the second direction h2 is greater than a length y2 of the second color light-emitting element 202 in the second direction h2, and a length y3 of the first color light-emitting element 201 in the second direction h2 is greater than a length y3 of the third color light-emitting element 203 in the second direction h2.

In a same light-emitting element group 200, the first color light-emitting element 201 and the second color light-emitting element 202 are arranged in the first direction h1, the first color light-emitting element 201 and the third color light-emitting element 203 are arranged in the first direction h1, and the second color light-emitting element 202 and the third color light-emitting element 203 are arranged in the second direction h2. Exemplarily, the first color may be blue, the second color may be one of green and red, and the third color may be another one of green and red.

In an embodiment, as shown in FIG. 1, the first light-adjusting interface 31 at least includes a fifth light-adjusting sub-interface 313, and an orthographic projection of the fifth light-adjusting sub-interface 313 onto the plane of the substrate 1 is located between the third color light-emitting element 203 of one of the light-emitting element groups 200 and the second color light-emitting element 202 of another light-emitting element group 200. The second light-adjusting interface 32 at least includes a sixth sub-light-adjusting interface 323, and an orthographic projection of the sixth sub-light-adjusting interface 323 onto the plane of the substrate 1 is located between the third color light-emitting element 203 of one of the light-emitting element groups 200 and the second color light-emitting element 202 of another light-emitting element group 200. Based on this arrangement, the large-angle light emitted from the third color light-emitting element 203 of one of the light-emitting element groups 200 and the large-angle light emitted from the second color light-emitting element 202 of another light-emitting element group 200 can be adjusted by the fifth sub-light-adjusting interface 313 and the sixth sub-light-adjusting interface 323 located therebetween, and emitted from the display panel as small-angle light, so as to achieve the large-viewing-angle anti-peeping effect of the display panel in the second direction h2.

FIG. 1 illustrates two fifth sub-light-adjusting interfaces 313 and one sixth sub-light-adjusting interface 323 between the third color light-emitting element 203 of one of the light-emitting element groups 200 and the second color light-emitting element 202 of another light-emitting element group 200. The sixth sub-light-adjusting interface 323 can not only adjust the large-angle light emitted by the third color light-emitting element 203 of one of the light-emitting element groups 200, but also adjust the large-angle light emitted by the second color light-emitting element 202 of another light-emitting element group 200.

Exemplarily, as shown in FIG. 1, in an embodiment of the present disclosure, an orthographic projection of the support portion 6 onto the plane of the substrate 1 may be located between two adjacent first color light-emitting elements 201 in the second direction h2. Based on this arrangement, the support portion 6 may be separately disposed in different regions of the display panel from the first light-adjusting interface 31 and the second light-adjusting interface 32, thereby making rational use of the space in the region of the display panel where no light-emitting elements 2 are arranged.

Exemplarily, as shown in FIG. 1, the display panel includes a light-adjusting assembly 3. The light-adjusting assembly 3 includes the first light-adjusting interface 31 and the second light-adjusting interface 32. The light-adjusting assembly 3 and the support portion 6 are arranged in the first direction h1. Based on this arrangement, both the light-adjusting assembly 3 and the support portion 6 may be located between two adjacent light-emitting element groups 200, which may improve the distribution uniformity of the light-adjusting assembly 3 and the support portion 6 in the display panel.

In an embodiment, as shown in FIG. 1, the first color light-emitting element 201 includes a first sub-light-emitting element 2011 and a second sub-light-emitting element 2012 arranged in the second direction h2, and a third sub-light-emitting element 2013 and a fourth sub-light-emitting element 2014 arranged in the second direction h2.

For example, when providing each first-color light-emitting element 201, as shown in FIG. 1, in an embodiment of the present disclosure, a distance d1 between the first sub-light-emitting element 2011 and the second sub-light-emitting element 2012 may be equal to a distance d2 between the third sub-light-emitting element 2013 and the fourth sub-light-emitting element 2014 in the second direction h2.

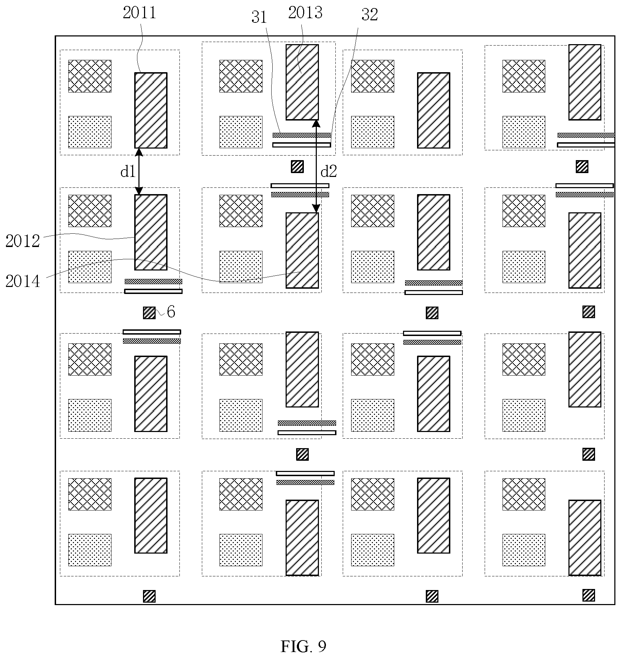

Alternatively, as shown in FIG. 9, which is a schematic top view of another display panel according to an embodiment of the present disclosure, a distance d1 between the first sub-light-emitting element 2011 and the second sub-light-emitting element 2012 is smaller than a distance d2 between the third sub-light-emitting element 2013 and the fourth sub-light-emitting element 2014 in the second direction h2. As shown in FIG. 9, at least two of the support portion 6, the first light-adjusting interface 31 and the second light-adjusting interface 32 are provided between the third sub-light-emitting element 2013 and the fourth sub-light-emitting element 2014. FIG. 9 illustrates that a support portion 6, a first light-adjusting interface 31, and a second light-adjusting interface 32 are provided between the third sub-light-emitting element 2013 and the fourth sub-light-emitting element 2014. As an example, two first light-adjusting interfaces 31 and two second light-adjusting interfaces 32 are provided between the third sub-light-emitting element 2013 and the fourth sub-light-emitting element 2014. Based on this arrangement, a relatively large space between the third sub-light-emitting element 2013 and the fourth sub-light-emitting element 2014 can be reasonably utilized, while ensuring that the support portion 6, the first light-adjusting interface 31, and the second light-adjusting interface 32 do not affect the small-angle light emitted by the light-emitting element 2, the requirements on the preparation process capability of the support portion 6, the first light-adjusting interface 31, and the second light-adjusting interface 32 can be reduced, which is beneficial to reducing the process difficulty.

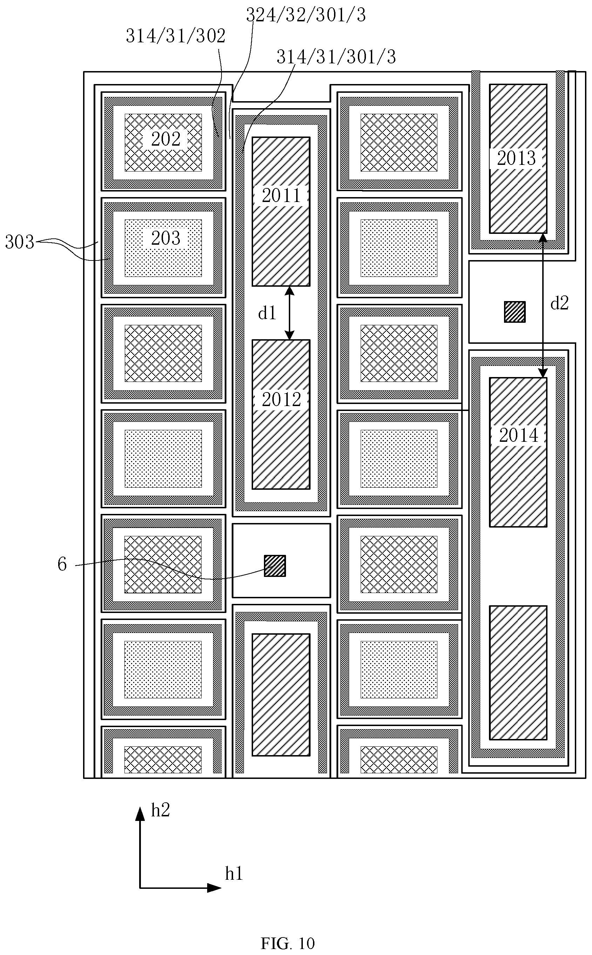

In an embodiment, as shown in FIG. 10, which is a schematic top view of another display panel according to an embodiment of the present disclosure, the first light-adjusting interface 31 further includes a seventh light-adjusting interface 314. An orthographic projection of the seventh light-adjusting interface 314 onto the plane of the substrate 1 is located between the first color light-emitting element 201 and the second color light-emitting element 202; and/or an orthographic projection of the seventh light-adjusting interface 314 onto the plane of the substrate 1 is located between the first color light-emitting element 201 and the third color light-emitting element 203.

As shown in FIG. 10, the second light-adjusting interface 32 further includes an eighth sub-light-adjusting interface 324. An orthographic projection of the eighth sub-light-adjusting interface 324 onto the plane of the substrate 1 is located between the first color light-emitting element 201 and the second color light-emitting element 202; and/or an orthographic projection of the eighth sub-light-adjusting interface 324 onto the plane of the substrate 1 is located between the first color light-emitting element 201 and the third color light-emitting element 203.

The arrangement of the seventh sub-light-adjusting interface 314 and the eighth sub-light-adjusting interface 324 may adjust the emitted direction of the large-angle light that is emitted by the first color light-emitting element 201 and the second color light-emitting element 202 towards two sides of the first direction h1, thereby adjusting this part of large-angle light into small-angle light for emission, and thus improving the large-viewing-angle anti-peeping effect of the display panel in the first direction h1.

Exemplarily, as shown in FIG. 10, the display panel includes a light-adjusting assembly 3 including a first light-adjusting interface 31 and a second light-adjusting interface 32. The light-adjusting assembly 3 includes a first light-adjusting assembly 301 at least partially surrounding the first color light-emitting element 201, a second light-adjusting assembly 302 at least partially surrounding the second color light-emitting element 202, and a third light-adjusting assembly 303 at least partially surrounding the third color light-emitting element 203.

It should be noted that the light-emitting element 2 being configured as a quadrilateral shape as shown in FIG. 10 is merely an example, and it may also be configured as any other shape according to different design requirements in the embodiments of the present disclosure.

When the light-emitting element 2 is configured as a quadrilateral shape, as shown in FIG. 10, each side of the light-emitting element 2 is correspondingly provided with a first light-adjusting interface 31 and a second light-adjusting interface 32. Based on this arrangement, the first light-adjusting interface 31 and the second light-adjusting interface 32 can be configured to adjust the large-angle light of the light-emitting element 2 from multiple orientations, so as to reduce the light intensity of the display panel at the large-viewing-angle in multiple orientations, thereby improving the anti-peeping effect of the display panel at the large-viewing-angle in multiple orientations. Moreover, based on this arrangement, the light intensity of the display panel at the front viewing-angle can be further improved.

It should be noted that FIG. 10 only illustrates d1≠d2, and when the light-adjusting assembly 3 is configured to include the first light-adjusting assembly 301 at least partially surrounding the first color light-emitting element 201, the second light-adjusting assembly 302 at least partially surrounding the second color light-emitting element 202, and the third light-adjusting assembly 303 at least partially surrounding the third color light-emitting element 203, d1 may also be configured to be not equal to d2, which is not illustrated herein.

Exemplarily, as shown in FIG. 10, the second light-adjusting interface 32 in the first light-adjusting assembly 301 may be reused as the second light-adjusting interface in the second light-adjusting assembly 302, or may be reused as the second light-adjusting interface 32 in the third light-adjusting assembly 303. The second light-adjusting interface in the second light-adjusting assembly 302 may also be reused as the second light-adjusting interface 32 in the third light-adjusting assembly 303.

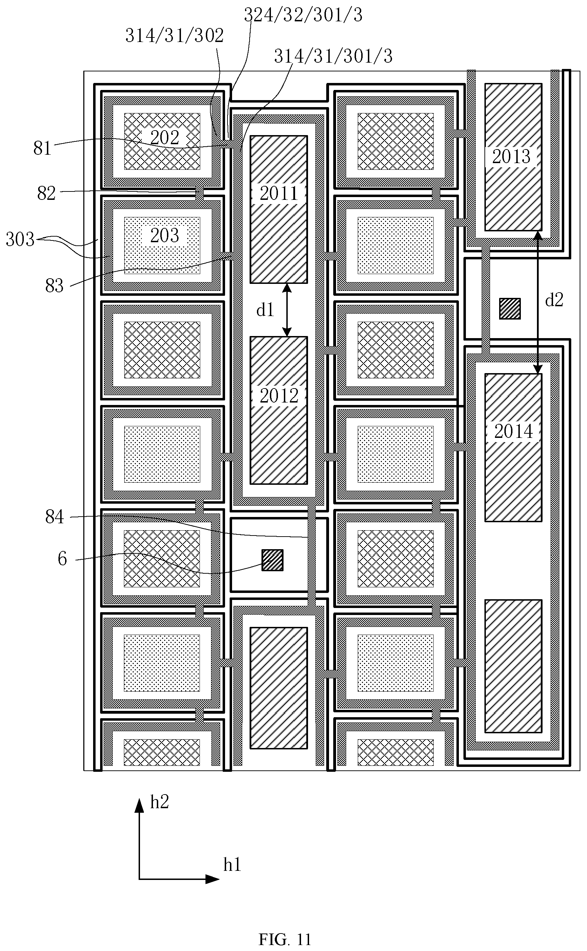

Exemplarily, as shown in FIG. 11, which is a schematic top view of another display panel according to an embodiment of the present disclosure, the display panel further includes at least one of a first connection assembly 81, a second connection assembly 82, a third connection assembly 83 and a fourth connection assembly 84. The first connection assembly 81 connects the first light-adjusting assembly 301 and the second light-adjusting assembly 302 adjacent to each other in the first direction h1. The second connection assembly 82 connects the second light-adjusting assembly 302 and the third light-adjusting assembly 303 adjacent to each other in the second direction h2. The third connection assembly 83 connects the third light-adjusting assembly 303 and the first light-adjusting assembly 301 adjacent to each other in the first direction h1. The fourth connection assembly 84 connects two first light-adjusting assemblies 301 adjacent to each other in the second direction h2. The arrangement of at least one of the first connection assembly 81, the second connection assembly 82, the third connection assembly 83 and the fourth connection assembly 84 can make the shape of the orthographic projection of the light-adjusting assembly 3 onto the plane of the display panel be formed as a grid-like structure, which is beneficial to improving the pattern consistency of different regions in the display panel.

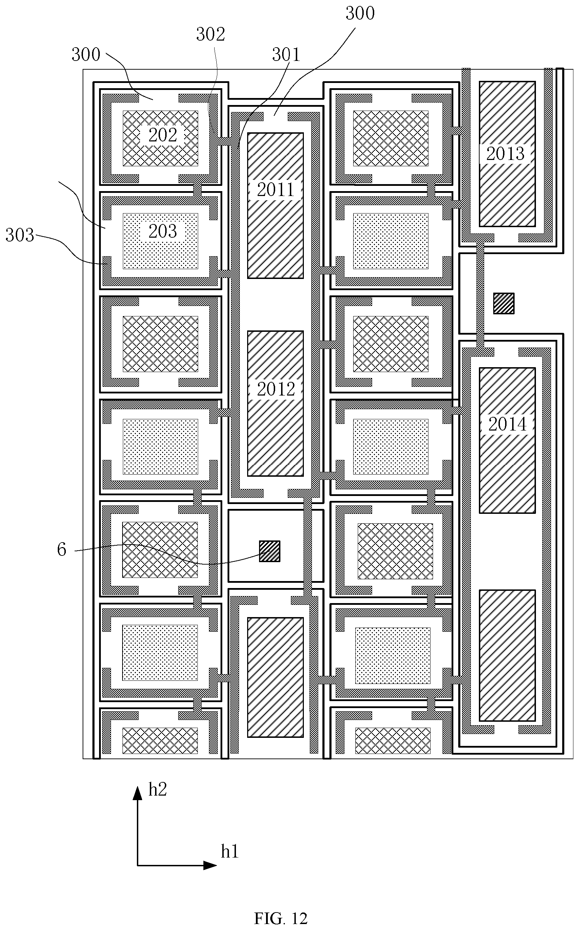

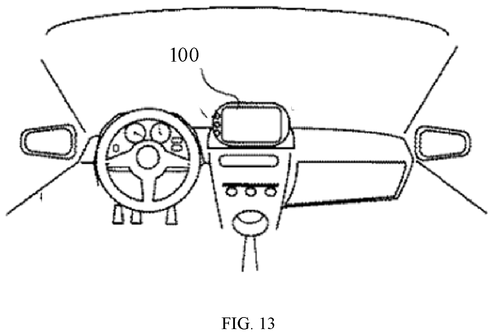

Exemplarily, as shown in FIG. 12, which is a schematic top view of another display panel according to an embodiment of the present disclosure, at least one of the first light-adjusting assembly 301, the second light-adjusting assembly 302 and the third light-adjusting assembly 303 includes a notch 300. FIG. 13 illustrates that the first light-adjusting interface 31 in the first light-adjusting assembly 301 includes a notch 300, the first light-adjusting interface 31 in the second light-adjusting assembly 302 includes a notch 300, and the first light-adjusting interface 31 in the third light-adjusting assembly 303 includes a notch 300.

The arrangement of the notch 300 can prevent the second electrode 202 formed after the first light-adjusting interface 31 and the second light-adjusting interface 32 from being disconnected or thinned at the first light-adjusting interface 31 and the second light-adjusting interface 32, which enables the second electrode 202 of the light-emitting element 2 to be formed as a continuous structure with a relatively large thickness at the first light-adjusting interface 31 and second light-adjusting interface 32, thereby being beneficial to reducing a voltage drop of the signal transmitted by the second electrode 202 during transmission, improving the voltage uniformity of the second electrode 202 in the display region, and thus improving the display uniformity of the display panel.

Based on a same inventive concept, an embodiment of the present disclosure further provides a display device, as shown in FIG. 13, which is a schematic diagram of a display device according to an embodiment of the present disclosure. The display device includes the above-mentioned display panel 100. The specific structure of the display panel 100 has been described in detail in the foregoing embodiments, and details are not described herein again. It is understandable that, the display device shown in FIG. 13 is merely illustrative, and the display device can be any electronic device having a display function such as a mobile phone, a tablet computer, a notebook computer, an electronic paper book, a vehicle-mounted display screen, or a television.

The above description is only a preferred embodiment of the present disclosure and is not intended to limit the present disclosure, and any modification, equivalent substitution, improvement and the like made within a spirit and a principle of the present disclosure should be included within the protection scope of the present disclosure.

It should be noted that the above embodiments are used to illustrate the technical solutions of the present disclosure but not to make any limitation. Although the present disclosure has been described in detail with reference to the embodiments above, those of ordinary skill in the art should understand that they can still modify the technical solutions described in the embodiments above or make equivalent replacement of some or all of the technical features. These modifications or replacements do not cause the essence of the corresponding technical solutions to depart from the scope of the technical solutions of the embodiments of the present disclosure.

## Claims

1. A display panel, **characterized by** comprising
a substrate;
a light-emitting element located on a side of the substrate;
a first light-adjusting interface protruding towards a direction away from the substrate and misaligned with the light-emitting element in a direction perpendicular to a plane of the substrate; and
a second light-adjusting interface recessed towards the substrate and misaligned with the light-emitting element in the direction perpendicular to the plane of the substrate,
wherein the first light-adjusting interface and the second light-adjusting interface are misaligned with each other in the direction perpendicular to the plane of the substrate.

2. The display panel according to claim 1, **characterized in that** at least part of the first light-adjusting interface is located at a light-exiting side of the light-emitting element.

3. The display panel according to claim 1, **characterized in that** the second light-adjusting interface is located between two adjacent first light-adjusting interfaces in a direction parallel to the plane of the substrate.

4. The display panel according to claim 1, **characterized in that** the display panel further comprises:
a pixel definition layer, wherein the pixel definition layer comprises a first opening, the light-emitting element comprises a light-emitting layer, and at least part of the light-emitting layer is located in the first opening; and
a protrusion portion protruding from a surface of the pixel definition layer towards a direction away from the substrate, wherein the protrusion portion comprises a first surface away from the substrate,
wherein the first light-adjusting interface comprises the first surface.

5. The display panel according to claim 4,
**characterized in that** the pixel definition layer further comprises a second opening; and at least part of the second light-adjusting interface comprises a side wall of the second opening;
the protrusion portion comprises a first bottom surface close to the substrate; and
the second opening comprises a first top surface away from the substrate, the first bottom surface and the first top surface are located on a same horizontal plane that is parallel to the plane of the substrate.

6. The display panel according to claim 4, **characterized in that** the display panel further comprises a support portion protruding from a surface of the pixel definition layer towards a direction away from the substrate;
wherein the support portion comprises a second surface away from the substrate; and
in the direction perpendicular to the plane of the substrate, a distance between the first surface and the light-emitting element is h1, and a distance between the second surface and the light-emitting element is h2, where 0<h1<h2≤3µm.

7. The display panel according to claim 6,
**characterized in that** the first surface intersects with the surface of the pixel definition layer at a first intersection line, and an included angle between a tangent line of the first surface at the first intersection line and the plane of the substrate is θ1, the second surface intersects the surface of the pixel definition layer at a second intersection line, and an included angle between a tangent line of the second surface at the second intersection line and the plane of the substrate is θ2, where 45°≤θ1≤θ2≤90°.

8. The display panel according to claim 6,
**characterized in that** in a direction parallel to the plane of the substrate, a distance between the protrusion portion and a light-emitting element closest to the protrusion portion is L1, and a distance between the support portion and a light-emitting element closest to the support portion is L2, where L1≤L2.

9. The display panel according to claim 4, **characterized in that**
a width of the protrusion portion gradually decreases along a direction away from the substrate.

10. The display panel according to claim 4, **characterized in that** the display panel further comprises a first film layer covering the protrusion portion,
wherein a refractive index of the first film layer is smaller than a refractive index of the protrusion portion.

11. The display panel according to claim 10, **characterized in that** the light-emitting element comprises a first electrode, a light-emitting layer, a common layer and a second electrode stacked in the direction perpendicular to the plane of the substrate, and the first film layer comprises the common layer.

12. The display panel according to claim 4, **characterized in that** a cross-sectional shape of the protrusion portion in the direction perpendicular to the plane of the substrate comprises any one of a triangle, a trapezoid, or an arc.

13. The display panel according to claim 1, **characterized in that** a side of the first light-adjusting interface away from the substrate comprises a planar surface or a curved surface.

14. The display panel according to claim 1, **characterized in that** at least part of the second light-adjusting interface is located at a side of the light-emitting element close to the substrate.

15. The display panel according to claim 1, **characterized in that** the display panel further comprises a pixel definition layer,
wherein the pixel definition layer comprises a first opening and a second opening, the light-emitting element comprises a light-emitting layer, and at least part of the light-emitting layer is located in the first opening; and a side wall of the second opening comprises at least part of the second light-adjusting interface.

16. The display panel according to claim 15, **characterized in that** the display panel further comprises a planarization layer located at a side of the pixel definition layer close to the substrate,
wherein the planarization layer comprises a third opening, the third opening at least partially overlaps with the second opening in the direction perpendicular to the plane of the substrate, and at least part of the second light-adjusting interface comprises a side wall of the third opening.

17. The display panel according to claim 16, **characterized in that** the display panel further comprises a second film layer at least partially located in the second opening and the third opening,
wherein a refractive index of the second film layer is greater than a refractive index of the pixel definition layer, and the refractive index of the second film layer is greater than a refractive index of the planarization layer.

18. The display panel according to claim 17, **characterized in that** the light-emitting element comprises a first electrode, a light-emitting layer, a common layer and a second electrode stacked in the direction perpendicular to the plane of the substrate; and the second film layer comprises the common layer, and the common layer comprises at least one of a hole injection layer or a hole transport layer.

19. The display panel according to claim 15, **characterized in that**
a width of the second opening gradually decreases along a direction close to the substrate.

20. The display panel according to claim 1,
**characterized in that** the display panel comprises more than one first light-adjusting interface and second light-adjusting interface disposed corresponding to one of the light-emitting elements;
the light-emitting elements comprise a first color light-emitting element and a second color light-emitting element, and a light-emitting efficiency of the first color light-emitting element is smaller than a light-emitting efficiency of the second color light-emitting element;
the first light-adjusting interface comprises a first sub-light-adjusting interface disposed corresponding to the first color light-emitting element and a second sub-light-adjusting interface disposed corresponding to the second color light-emitting element;
the second light-adjusting interface comprises a third sub-light-adjusting interface disposed corresponding to the first color light-emitting element and a fourth sub-light-adjusting interface disposed corresponding to the second color light-emitting element; and
a number of the first sub-light-adjusting interfaces is greater than a number of the second sub-light-adjusting interfaces; and/or a number of the third sub-light-adjusting interfaces is greater than a number of the fourth sub-light-adjusting interfaces.

21. The display panel according to claim 1, **characterized in that** the display panel further comprises light-emitting element groups arranged in an array in a first direction and a second direction,
wherein the first direction intersects with the second direction; one light-emitting element group of the light-emitting element groups comprises light-emitting elements, and the light-emitting elements comprise a first color light-emitting element, a second color light-emitting element, and a third color light-emitting element; a length of the first color light-emitting element in the second direction is greater than a length of the second color light-emitting element in the second direction, and the length of the first color light-emitting element in the second direction is greater than a length of the third color light-emitting element in the second direction; and
in one light-emitting element group of the light-emitting element groups, the first color light-emitting element and the second color light-emitting element are arranged in the first direction, the first color light-emitting element and the third color light-emitting element are arranged in the first direction, and the second color light-emitting element and the third color light-emitting element are arranged in the second direction.

22. The display panel according to claim 21, **characterized in that**
the first light-adjusting interface comprises at least a fifth light-adjusting sub-interface, and an orthographic projection of the fifth light-adjusting sub-interface onto the plane of the substrate is located between the third color light-emitting element of one light-emitting element group of the light-emitting element groups and the second color light-emitting element of another one light-emitting element group of the light-emitting element groups; and
the second light-adjusting interface comprises at least a sixth light-adjusting sub-interface, and an orthographic projection of the second light-adjusting sub-interface onto a plane of the substrate is located between the third color light-emitting element of one light-emitting element group of the light-emitting element groups and the second color light-emitting element of another one light-emitting element group of the light-emitting element groups.

23. The display panel according to claim 21, **characterized in that** the display panel further comprises a support portion protruding from a surface of the pixel definition layer towards a direction away from the substrate,
wherein an orthographic projection of the support portion onto the plane of the substrate is located between two adjacent first color light-emitting elements arranged in the second direction.

24. The display panel according to claim 23, **characterized in that** the display panel comprises a light-adjusting assembly, the light-adjusting assembly comprises the first light-adjusting interface and the second light-adjusting interface, and the light-adjusting assembly and the support portion are arranged in the first direction.

25. The display panel according to claim 23,
**characterized in that** the first color light-emitting element comprises a first sub-light-emitting element and a second sub-light-emitting element arranged in the second direction, and a third sub-light-emitting element and a fourth sub-light-emitting element arranged in the second direction;
a distance d1 between the first sub-light-emitting element and the second sub-light-emitting element in the second direction is smaller than a distance d2 between the third sub-light-emitting element and the fourth sub-light-emitting element in the second direction; and
at least two of the support portion, the first light-adjusting interface and the second light-adjusting interface are provided between the third sub-light-emitting element and the fourth sub-light-emitting element.

26. The display panel according to claim 21,
**characterized in that** the first light-adjusting interface further comprises a seventh light-adjusting sub-interface, and an orthographic projection of the seventh light-adjusting sub-interface onto the plane of the substrate is located between the first color light-emitting element and the second color light-emitting element; and/or, an orthographic projection of the seventh light-adjusting sub-interface onto the plane of the substrate is located between the first color light-emitting element and the third color light-emitting element; and
the second light-adjusting interface further comprises an eighth sub-light-adjusting interface, and an orthographic projection of the eighth sub-light-adjusting interface onto the plane of the substrate is located between the first color light-emitting element and the second color light-emitting element; and/or an orthographic projection of the eighth sub-light-adjusting interface onto the plane of the substrate is located between the first color light-emitting element and the third color light-emitting element.

27. The display panel according to claim 21,
**characterized in that** the first color light-emitting element comprises a first sub-light-emitting element and a second sub-light-emitting element arranged in the second direction, and a third sub-light-emitting element and a fourth sub-light-emitting element arranged in the second direction; and
a distance between the first sub-light-emitting element and the second sub-light-emitting element in the second direction is equal to a distance between the third sub-light-emitting element and the fourth sub-light-emitting element in the second direction.

28. The display panel according to claim 21,
**characterized in that** the display panel comprises a light-adjusting assembly, and the light-adjusting assembly comprises the first light-adjusting interface and the second light-adjusting interface; and
the light-adjusting assembly comprises a first light-adjusting assembly at least partially surrounding the first color light-emitting element, a second light-adjusting assembly at least partially surrounding the second color light-emitting element, and a third light-adjusting assembly at least partially surrounding the third color light-emitting element.

29. The display panel according to claim 28, **characterized in that** the display panel further comprises at least one of a first connection assembly, a second connection assembly, a third connection assembly or a fourth connection assembly,
wherein the first connection assembly connects the first light-adjusting assembly and the second light-adjusting assembly that are adjacent in the first direction, the second connection assembly connects the second light-adjusting assembly and the third light-adjusting assembly that are adjacent in the second direction, the third connection assembly connects the third light-adjusting assembly and the first light-adjusting assembly that are adjacent in the first direction, and the fourth connection assembly connects two first light-adjusting assemblies that are adjacent to each other in the second direction.

30. The display panel according to claim 28, **characterized in that** at least one of the first light-adjusting assembly, the second light-adjusting assembly, or the third light-adjusting assembly comprises a notch.

31. A display device, **characterized by** comprising the display panel according to any one of claims 1 to 30.
